# EUROPÄISCHE PATENTANMELDUNG

(11) **EP 1 615 338 A1**
(43) Veröffentlichungstag der Anmeldung: **11.01.2006**
(21) Anmeldenummer: 04015907.1
(22) Anmeldetag: 06.07.2004
(51) Int. Cl.: H03F 1/32

(54) **Verfahren und Anordnung zur linearisierung einer Leistungsverstärkerkennlinie**

(71) Anmelder: SIEMENS AKTIENGESELLSCHAFT, 80333 München (DE)
(72) Erfinder: Jelonnek, Björn, Dr., 89079 Ulm (DE)

(57) **Zusammenfassung**

Die Erfindung betrifft ein Verfahren und eine Anordnung zur Linearisierung einer Leistungsverstärkerkennlinie. Dabei wird aus einem digitalen Eingangssignal durch Vorverzerrung ein erstes Signal gebildet, das nach einer Trägerfrequenzumsetzung, einer D/A-Wandlung und einer Modulation einem Leistungsverstärker zur Bildung eines trägerfrequenten Ausgangssignals zugeführt wird. Zur Linearisierung der Leistungsverstärkerkennlinie wird die Vorverzerrung durch Parameter gesteuert durchgeführt. Dem ersten Signal wird ein Testsignal überlagert, wodurch das Ausgangssignal neben einem trägerfrequenten Eingangssignalanteil zusätzlich einen trägerfrequenten Testsignalanteil aufweist. Durch einen Vergleich des trägerfrequenten Testsignalanteils des Ausgangssignals mit dem Testsignal werden die Parameter zur Steuerung der Vorverzerrung gebildet.
Alternativ dazu ist es auch möglich, das Testsignal vor der durchzuführenden Vorverzerrung zu überlagern.

## Beschreibung

Die Erfindung betrifft ein Verfahren zur Linearisierung einer Leistungsverstärkerkennlinie gemäß dem Oberbegriff der Patentansprüche 1 und 3 sowie eine Anordnung zur Linearisierung einer Leistungsverstärkerkennlinie.

Zur Nachrichtensignalübertragung werden Leistungsverstärker verwendet, die breitbandige trägerfrequente Signale idealerweise hochlinear verstärken sollen. Um die Kennlinie des Leistungsverstärkers bezüglich der Linearität zu optimieren sind Vorverzerrungsverfahren bekannt. Dabei wird zur Bildung eines linear verstärkten Ausgangssignals das zu sendende Signal vor der Verstärkung derart vorverzerrt, dass Nichtlinearitäten der Verstärkerkennlinie ausgeglichen werden.

Die Vorverzerrung erfolgt üblicherweise im sogenannten Zwischenfrequenzbereich oder im komplexen Basisband des Signals, d.h. vor der Umsetzung in den Trägerfrequenzbereich, wobei die Vorverzerrung mit Hilfe von Parametern eingestellt wird. Die Parameter wiederum werden aus einem Vergleich des Leistungsverstärker-Ausgangssignals mit dem Signal vor der Vorverzerrung und/oder nach der durchgeführten Vorverzerrung gewonnen. Dadurch sind die ermittelten Parameter sowohl von den Eigenheiten des zu sendenden Signals und von den Betriebsparametern des Leistungsverstärkers abhängig und werden somit neben den elektrischen Kennwerten des Verstärkers auch durch dessen Umgebungstemperatur beeinflusst.

Die Parameter zur Steuerung der Vorverzerrung werden üblicherweise in einer multidimensionalen Tabelle abgespeichert und können beim Eintreten entsprechender Umstände wiederverwendet werden, wobei auch sich ändernde Umgebungstemperaturen berücksichtigt werden können.

Aufgrund der oben genannten Abhängigkeiten der Parameter sind derartige Tabellen sehr umfangreich und die Anpassung der Parameter ist nur sehr zeitaufwändig durchzuführen.

Es ist daher Aufgabe der vorliegenden Erfindung, ein Verfahren und eine Anordnung für eine schnelle und genaue durchzuführende Linearisierung einer Leistungsverstärkerkennlinie anzugeben, wobei die Linearisierung durch eine Signal-Vorverzerrung erfolgen soll.

Die Aufgabe der Erfindung wird durch ein Verfahren mit den Merkmalen der Patentansprüche 1 bzw. 3 sowie durch eine Anordnung mit den Merkmalen des Patentanspruchs 12 bzw. 14 gelöst. Vorteilhafte Weiterbildungen der Erfindung sind in den jeweiligen Unteransprüchen angegeben.

Bei der vorliegenden Erfindung wird einem ersten Signal, das beispielsweise als Mehrträgersignal vorliegt, ein Testsignal überlagert und dadurch ein zweites Signal gebildet. Das zweite Signal wird in eine Trägerfrequenzlage umgesetzt und einem Leistungsverstärker zur Bildung eines Ausgangssignals zugeführt. Insbesondere durch Vergleich eines im Ausgangssignal enthaltenen Testsignalanteils mit dem Testsignal werden Parameter zur Steuerung einer Vorverzerrung gebildet.

In einer ersten Ausführungsform der Erfindung wird ein Eingangssignal vorverzerrt, um das erste Signal zu bilden, wobei das Eingangssignal als Mehrträgersignal im komplexen digitalen Basisband oder umgesetzt in einer Zwischenfrequenzlage vorliegt.

In einer zweiten Ausführungsform liegt das erste Signal als Mehrträgersignal im komplexen digitalen Basisband oder umgesetzt in einer Zwischenfrequenzlage vor und wird erst nach erfolgter Testsignalüberlagerung vorverzerrt.

Das Testsignal weist besondere spektrale Eigenschaften auf. Bevorzugt wird ein Impulssignal verwendet, das eine vorbekannte, zeitvariante Amplitudenwert-Verteilung aufweist. Die einzelnen Amplituden werden derart gewählt, dass lediglich vernachlässigbare, vom Testsignal bedingte störende Anteile in denjenigen Frequenzbereichen gebildet werden, die zu einem zu nutzenden Trägerfrequenzbereich benachbart sind.

Vorteilhafterweise werden insbesondere aus dem im Ausgangssignal enthaltenen Testsignalanteil durch Vergleich mit dem Testsignal weitere Parameter gewonnen, mit denen die Bildung des Testsignals gesteuert wird. Dadurch wird die Unterdrückung der vorstehend genannten störenden Anteile in den benachbarten Frequenzbereichen ermöglicht.

In einer vorteilhaften Weiterbildung der Erfindung erfolgt im Basisband an dem Signal, das im weiteren Verlauf zur Überlagerung mit dem Testsignal verwendet werden soll, ein Basisband-Clipping-Verfahren. Durch Analyse des Ausgangssignals ist es möglich, Parameter zur Steuerung des Basisband-Clipping-Verfahrens zu bilden.

Das Basisband-Clipping-Verfahren wird somit am komplexen Basisbandsignal angewendet, aus dem nach durchgeführtem Basisband-Clipping-Verfahren, nach Interpolation und Modulation und nach gegebenenfalls durchgeführter Vorverzerrung bei der ersten Ausführungsform das erste Signal entsteht.

Das Basisband-Clipping-Verfahren wird verwendet, um mögliche maximale Sendeleistungswerte des Ausgangssignals auf einen fest vorgegebenen Wert zu reduzieren. Bei kleineren Amplituden des Basisbandsignals wird das Basisband-Clipping-Verfahren nicht verwendet.

Vorteilhafterweise wird dabei eine flexibel einstellbare Clipping-Schwelle verwendet, die entsprechend einer momentan verfügbaren Maximalleistung des Leistungsverstärkers veränderbar ist. Diese momentan verfügbare Maximalleistung ist insbesondere von der Umgebungstemperatur des Leistungsverstärkers abhängig. Die Parameter zur Steuerung des Clipping-Verfahrens werden in Abhängigkeit von der Umgebungstemperatur ermittelt und zur späteren Variation der Clipping-Schwelle in einer Tabelle abgelegt.

Durch die Gestaltung des Testsignals und durch die Verwendung des Testsignals bei der Beurteilung des Verhaltens des Leistungsverstärkers wird eine Reduktion der Anzahl der in der Tabelle enthaltenen Einträge ermöglicht. Eigenschaften bzw. Betriebszustände des Verstärkers werden schneller erfasst und ausgeglichen. Diese verkleinerte Tabelle ist insbesondere bei sprunghaften Änderungen des komplexen Basisband-Eingangssignals vorteilhaft.

Es ist möglich, das Basisband-Clipping-Verfahren und das Vorverzerrungsverfahren einheitlich für die jeweilige gesamte Ausführungsform zu betrachten, wodurch mit einer entsprechenden Einstellung eine gegenseitige Ergänzung ermöglicht wird.

Eine adaptive Nachführung der Clipping-Schwelle des Basisband-Clipping-Verfahrens ist mit einfachen Mitteln möglich.

Die Erfindung wird nachfolgend anhand einer Zeichnung näher erläutert. Dabei zeigt:
- FIG 1: als Blockschaltbild eine erfindungsgemäße erste Anordnung zur Linearisierung einer Leistungsverstärkerkennlinie,
- FIG 2: als Blockschaltbild eine erfindungsgemäße zweite Anordnung zur Linearisierung einer Leistungsverstärkerkennlinie,
- FIG 3: mit Bezug auf FIG 1 und FIG 2 ein beispielhaftes Testsignal,
- FIG 4: mit Bezug auf FIG 3 einen Testsignal-Frequenzgang,
- FIG 5: mit Bezug auf FIG 1 und FIG 2 das Ausgangssignal im zeitlichen Verlauf,
- FIG 6: mit Bezug auf FIG 1 und FIG 2 das Ausgangssignal in komplexer Darstellung,
- FIG 7: mit Bezug auf FIG 1 und FIG 2 den Ausgangssignal-Frequenzgang,
- FIG 8: einen seitens eines Empfängers gemessenen Ausgangssignal-Frequenzgang, und
- FIG 9: einen Vergleich eines erzielten Adaptionsergebnisses an eine nichtlineare Verstärkerkennlinie.

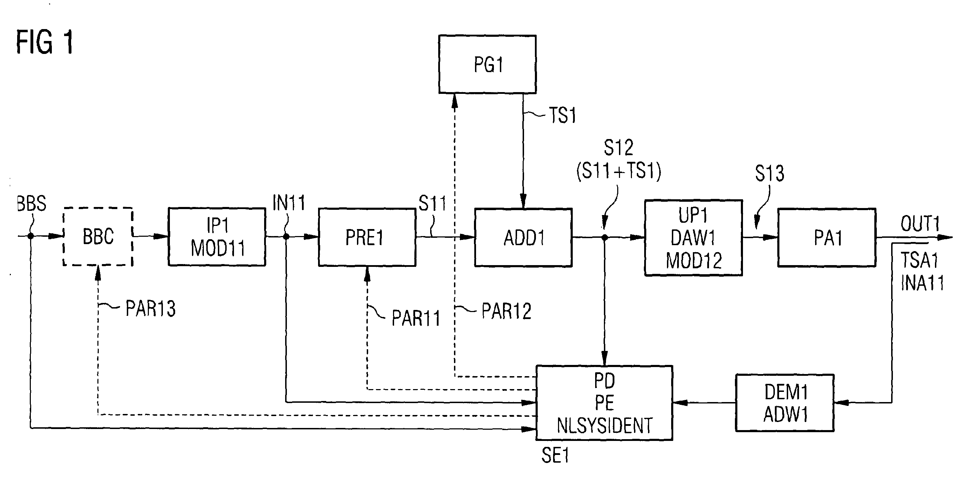

FIG 1 zeigt als Blockschaltbild eine erfindungsgemäße erste Anordnung zur Linearisierung einer Leistungsverstärkerkennlinie eines Leistungsverstärkers PA1.

Ein oder mehrere komplexe Basisbandsignale BBS gelangen an eine Interpolationseinrichtung IP1 und werden unter Verwendung eines ersten Modulators MOD11 in ein (Multicarrier-) Eingangssignal IN11 umgewandelt, wobei das Eingangssignal IN11 beispielsweise erhöht abgetastet in einer Zwischenfrequenzlage vorliegt. Das gebildete Eingangssignal IN11 gelangt an eine Vorverzerrungseinrichtung PRE1 und wird durch diese vorverzerrt, wodurch ein vorverzerrtes erstes Signal S11 gebildet wird. Die Vorverzerrungseinrichtung PRE1 wird durch einen ersten Parametersatz PAR11 gesteuert.

Das erste Signal S11 gelangt an eine Überlagerungseinrichtung ADD1, der zusätzlich ein von einem Pulsgenerator PG1 gebildetes Testsignal TS1 zugeführt wird.

Mit Hilfe der Überlagerungseinrichtung ADD1 wird beispielsweise durch additive Überlagerung des ersten Signals S11 mit dem Testsignal TS1 ein zweites Signal S12 gebildet.

Das zweite Signal S12 gelangt über eine Einrichtung zur Trägerfrequenzumsetzung UP1, über einen D/A-Wandler DAW1 und über einen zweiten Modulator MOD12 als trägerfrequentes drittes Signal S13 an den Leistungsverstärker PA1, der eine nichtlineare Verstärkerkennlinie aufweist. Der Leistungsverstärker PA1 bildet aus dem dritten Signal S13 ein leistungsverstärktes, trägerfrequentes Ausgangssignal OUT1.

Das trägerfrequente Ausgangssignal OUT1 weist somit sowohl Anteile des Eingangssignals IN11 als auch Anteile des Testsignals TS1 auf. Diese werden nachfolgend als Testsignalanteil TSA1 und als Eingangssignalanteil INA11 bezeichnet.

Das Ausgangssignal OUT1 gelangt beispielsweise durch Auskopplung anteilig über einen Demodulator DEM1 und über einen A/D-Wandler ADW1 an eine Steuereinrichtung SE1, der ebenfalls das zweite Signal S12 zugeführt wird. Das zweite Signal S12 beinhaltet wie vorstehend beschrieben aufgrund der Überlagerung neben dem ersten Signal S11 auch das Testsignal TS1.

Die Steuereinrichtung SE1 analysiert die Übertragung des Testsignals TS1, indem sie einen Zeitabschnitt mit dem Testsignalanteil TSA1 des Ausgangssignals OUT1 mit dem entsprechenden Zeitabschnitt des Testsignals TS1 vergleicht. Basierend auf diesem Vergleich wird durch die Steuereinrichtung SE1 der erste Parametersatz PAR11 gebildet, mit dem die Vorverzerrungseinrichtung PRE1 gesteuert wird. Durch diese Steuerung wird die Linearisierung der Kennlinie des Leistungsverstärkers PA1 erreicht.

Zur genaueren Bestimmung des Parametersatzes PAR11 ist auch ein zusätzlicher Vergleich des im Ausgangssignal OUT1 enthaltenen Eingangssignalanteils INA11 mit dem Eingangssignal IN11 in einer vorteilhaften Weiterbildung möglich.

In einer weiteren vorteilhaften Weiterbildung wird durch die Steuereinrichtung SE1 ein weiterer Parametersatz PAR12 gebildet, mit dem der Pulsgenerator PG1 gesteuert wird. Dieser Parametersatz PAR12 wird ebenfalls durch Vergleich des Testsignalanteils TSA1 des Ausgangssignals OUT1 mit dem Testsignal TS1 gebildet.

Durch die Steuerung der Bildung des Testsignals TS1 ist es möglich, störende trägerfrequente Anteile des Testsignals TSA1 in denjenigen Frequenzbereichen zu minimieren, die zu einem zu nutzenden Trägerfrequenzbereich des Ausgangssignals OUT1 benachbart sind. Übersteuerungen des Leistungsverstärkers werden vermieden.

Die Ermittlung der Parametersätze PAR11 und PAR12 erfolgt mit Hilfe eines Peak-Detektion-Verfahrens PD, eines Leistungsschätzungsverfahrens PE und/oder eines so genannten "NL system identification"-Verfahrens NLSYSIDENT mit Zielfunktionen. Diese sind beispielsweise bekannt aus dem Buch "Digital Communications", John G. Proakis, Seiten 601-635. Die zugehörigen Algorithmen der Zielfunktionen sind diesem Buch auf den Seiten 636 bis 679 zu entnehmen.

Verfahren zur Vorverzerrung sind beispielsweise aus der deutschen Patentanmeldung mit dem Aktenzeichen 10320420.2 bekannt, die am 07.05.2003 am Deutschen Patent- und Markenamt eingereicht wurde. Darin wird eine Projektion eines unterabgetasteten Ausgangssignals eines AD-Wandlers auf verschiedene Basisvektoren berechnet, die aus einem vorverzerrten Signal gewonnen werden. Die Projektion kann beispielsweise in Form einer Potenzreihenentwicklung erfolgen.

In einer vorteilhaften Weiterbildung der vorliegenden Erfindung wird der Steuereinrichtung SE1 zusätzlich das komplexe Basisbandsignal BBS zugeführt und zusätzlich mit dem im Ausgangssignal OUT beinhalteten Eingangssignalanteil INA11 und/oder mit dem im zweiten Signal S12 enthaltenen ersten Signal S11 verglichen. Damit wird eine genauere Bestimmung des Parametersatzes PAR11 ermöglicht.

Zusätzlich kann am komplexen Basisbandsignal BBS ein Basisband-Clipping-Verfahren BBC angewendet werden. In diesem Fall wird durch die Steuereinrichtung SE1 ein weiterer Parametersatz PAR13 gebildet, der zur Steuerung des Basisband-Clipping-Verfahrens verwendet wird. Bei der Bildung des Parametersatzes PAR13 wird neben dem Ausgangssignal OUT1 das zweite Signal S12 und/oder das Eingangssignal IN11 berücksichtigt.

Es wird eine adaptive Einstellung einer Clipping-Schwelle des Basisband-Clipping-Verfahren BBC realisiert, wobei diese adaptiv an die gesamte Anordndung bzw. an deren Übertragungseigenschaften angepasst wird. Diese Anpassung kann beispielsweise wie nachfolgend beschrieben durchgeführt werden. Durch die berechneten Parameter des Parametersatzes PAR11 oder durch die Verwendung des Peak-Detection-Verfahrens PD ist eine Maximalamplitude des Leistungsverstärkers PA1 bekannt, die weit über einem Maximalwert des dritten Signals S13 liegt. Damit kann die Clipping-Schwelle an Eigenschaften des Leistungsverstärkers PA1, insbesondere an dessen Umgebungstemperatur, Alterung, Streuung, ..., bzw. an die davon abhängigen Spitzenwerte der Ausgangsleistung des Ausgangssignals OUT1 angepasst werden.

Weiter werden bei einer drohenden Übersteuerung des Leistungsverstärkers PA1 höhere Signalpegel des Basisbandsignals BBS durch das Basisband-Clipping-Verfahren BBS stärker verringert, als das in einem normalen Anwendungsfall der Fall sein würde. Zusätzlich wird dann dem ersten Signal S11 das Testsignal TS1 phasenrichtig jedoch mit negativer Amplitude überlagert, um die maximale Amplitude des Ausgangssignals OUT1 zu reduzieren.

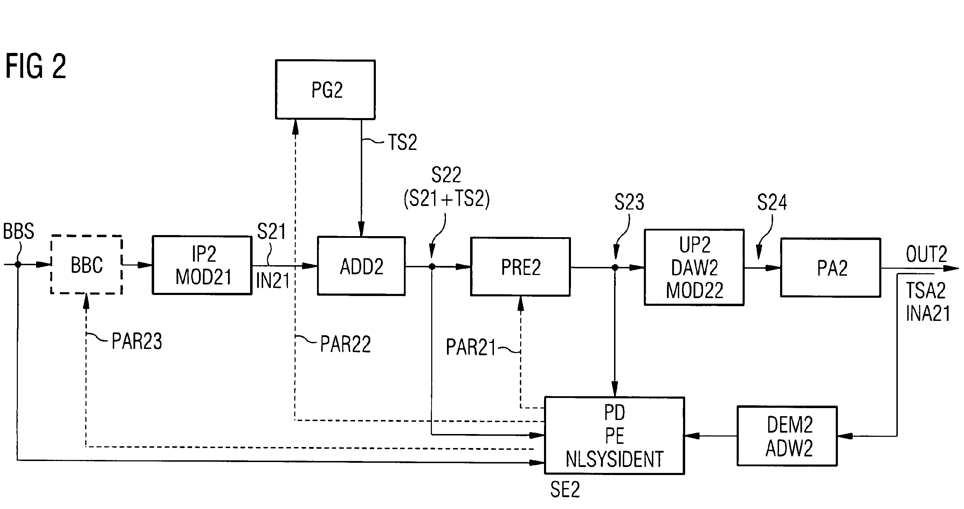

FIG 2 zeigt als Blockschaltbild eine erfindungsgemäße zweite Anordnung zur Linearisierung der Kennlinie eines Leistungsverstärkers PA2.

Das oder die komplexen Basisbandsignale BBS gelangen entweder über eine Einrichtung zur Durchführung eines Basisband-Clipping-Verfahrens BBC oder direkt an eine Interpolationseinrichtung IP2 und wird unter Verwendung eines ersten Modulators MOD21 in ein (Multicarrier-) Eingangssignal IN21 umgewandelt, wobei das Eingangssignal IN21 beispielsweise erhöht abgetastet in einer Zwischenfrequenzlage vorliegt.

Das Eingangssignal IN21 gelangt als erstes Signal S21 an eine Überlagerungseinrichtung ADD2, der zusätzlich ein von einem Pulsgenerator PG2 gebildetes Testsignal TS2 zugeführt wird.

Mit Hilfe der Überlagerungseinrichtung ADD2 wird beispielsweise durch additive Überlagerung des ersten Signals S21 mit dem Testsignal TS2 ein zweites Signal S22 gebildet.

Das zweite Signal S22 gelangt an eine Vorverzerrungseinrichtung PRE2 und wird durch diese vorverzerrt, wodurch ein vorverzerrtes drittes Signal S23 gebildet wird. Die Vorverzerrungseinrichtung PRE2 wird durch einen ersten Parametersatz PAR21 gesteuert.

Das dritte Signal S23 gelangt über eine Einrichtung zur Trägerfrequenzumsetzung UP2, über einen D/A-Wandler DAW2 und über einen zweiten Modulator MOD22 als trägerfrequentes viertes Signal S24 an den Leistungsverstärker PA2, der eine nichtlineare Verstärkerkennlinie aufweist. Der Leistungsverstärker PA2 bildet aus dem vierten Signal S24 ein leistungsverstärktes trägerfrequentes Ausgangssignal OUT2.

Somit weist das trägerfrequente Ausgangssignal OUT2 sowohl Anteile des ersten Signals S21 bzw. des Eingangssignals IN21 als auch Anteile des Testsignals TS2 auf. Diese werden nachfolgend als Eingangssignalanteil INA21 und als Testsignalanteil TSA2 bezeichnet.

Das Ausgangssignal OUT2 gelangt beispielsweise durch Auskopplung anteilig über einen Demodulator DEM2 und über einen A/D-Wandler ADW2 an eine Steuereinrichtung SE2, der ebenfalls das zweite Signal S22 und/oder das dritte Signal S23 zugeführt werden.

Das zweite Signal S22 beinhaltet wie vorstehend beschrieben aufgrund der Überlagerung neben dem ersten Signal S21 auch das Testsignal TS2.

Die Steuereinrichtung SE2 analysiert die Übertragung des Testsignals TS2, indem sie den Testsignalanteil TSA2 des Ausgangssignals OUT2 mit dem im zweiten Signal S22 beinhalteten Testsignal TS2 vergleicht. Basierend auf diesem Vergleich wird durch die Steuereinrichtung SE2 der erste Parametersatz PAR21 gebildet, mit dem die Vorverzerrungseinrichtung PRE2 gesteuert wird. Durch diese Steuerung wird die Linearisierung der Kennlinie des Leistungsverstärkers PA2 erreicht.

Zur genaueren Bestimmung des Parametersatzes PAR21 ist auch ein zusätzlicher Vergleich des im Ausgangssignal OUT2 enthaltenen Eingangssignalanteils INA21 mit dem im zweiten Signal S22 beinhalteten ersten Signal S21 und/oder mit dem dritten Signal S23 in einer vorteilhaften Weiterbildung möglich.

In einer vorteilhaften Weiterbildung wird durch die Steuereinrichtung SE2 ein weiterer Parametersatz PAR22 gebildet, mit dem der Pulsgenerator PG2 gesteuert wird. Zur Bildung des Parametersatzes PAR22 wird wiederum der im Ausgangssignal OUT2 enthaltene Testsignalanteil TSA2 mit dem im zweiten Signal S22 beinhalteten Testsignal TS2 in zugeordneten Zeitabschnitten verglichen.

In einer vorteilhaften Weiterbildung werden zusätzlich einander zuordenbare Signalanteile des Ausgangssignals OUT2 bzw. des zweiten Signals S22 ausgewertet.

Durch die Steuerung der Bildung des Testsignals TS2 ist es möglich, störende Anteile des Testsignals TSA2 in denjenigen Frequenzbereichen zu minimieren, die zu einem zu nutzenden Trägerfrequenzbereich des Ausgangssignals OUT2 benachbart sind.

Die Ermittlung der Parametersätze PAR21 und PAR22 erfolgt mit den bereits in FIG 1 beschriebenen Verfahren.

In einer vorteilhaften Weiterbildung wird der Steuereinrichtung SE2 zusätzlich das komplexe Basisbandsignal BBS zugeführt. Durch einen zusätzlichen Vergleich des Basisbandsignals BBS mit dem im Ausgangssignal OUT2 beinhalteten Eingangssignalanteil INA21 und/oder mit dem im zweiten Signal S22 enthaltenen Eingangssignal IN21, das dem ersten Signal S21 entspricht, und/oder mit dem entsprechenden Eingangssignalanteil des dritten Signals S23 wird ebenfalls eine genauere Bestimmung des Parametersatzes PAR21 ermöglicht.

Bei Verwendung der Einrichtung zur Durchführung des Basisband-Clipping-Verfahrens BBC wird durch die Steuereinrichtung SE2 ein weiterer Parametersatz PAR23 gebildet, der das Basisband-Clipping-Verfahren steuert. Bei der Bildung des Parametersatzes PAR23 wird neben dem Ausgangssignal OUT2 das komplexe Basisbandsignal BBS und/oder das zweite Signal S22 und/oder das dritte Signal S23 berücksichtigt.

Dadurch wird eine adaptive Einstellung einer Clipping-Schwelle realisiert, die beim Basisband-Clipping-Verfahren BBC verwendet wird. Diese Clipping-Schwelle wird adaptiv an die gesamte Anordndung bzw. an deren Übertragungseigenschaften angepasst.

Diese Anpassung kann beispielsweise wie nachfolgend beschrieben durchgeführt werden. Durch die berechneten Parameter des Parametersatzes PAR21 oder durch die Verwendung des Peak-Detection-Verfahrens PD ist eine Maximalamplitude des Leistungsverstärkers PA2 bekannt, die weit über einen Maximalwert des vierten Signals S24 liegt. Damit kann die Clipping-Schwelle an Eigenschaften des Leistungsverstärkers PA2, insbesondere an dessen Umgebungstemperatur, Alterung, Streuung, usw., bzw. an die davon abhängigen Spitzenwerte der Ausgangsleistung des Ausgangssignals OUT2 angepasst werden.

In einem weiteren Anwendungsfall werden bei einer drohenden Übersteuerung des Leistungsverstärkers PA2 höhere Signalpegel des Basisbandsignals BBS weiter verringert. Zusätzlich wird dem Eingangssignal IN21 ein Testsignal TS2 phasenrichtig jedoch mit negativer Amplitude überlagert. Damit wird eine maximale Amplitude des Ausgangssignals OUT2 reduziert.

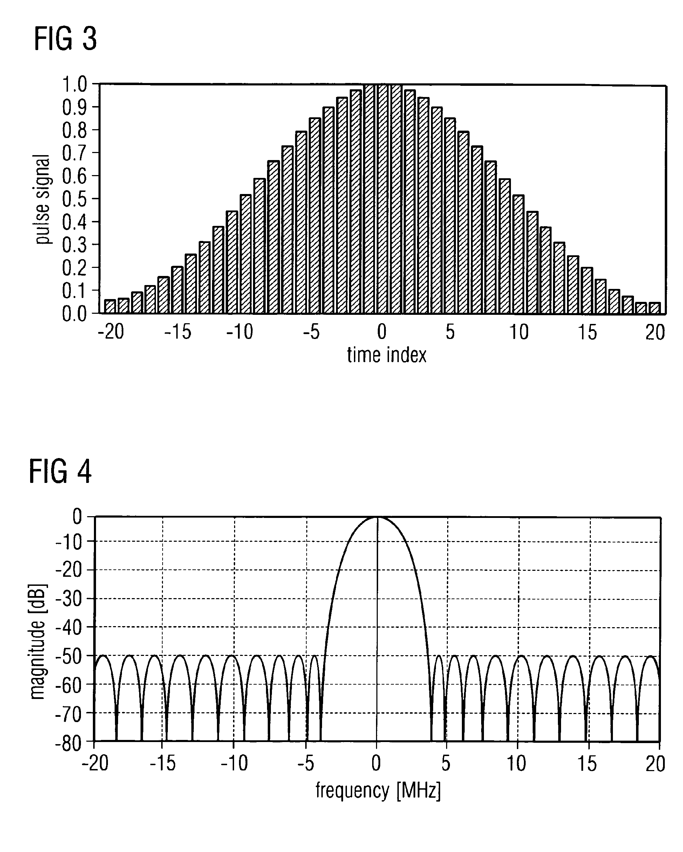

FIG 3 zeigt mit Bezug auf FIG 1 und FIG 2 ein beispielhaftes Testsignal TS1 bzw. TS2, das eine zeitvariante Amplitudenstatistik aufweist.

Auf der horizontalen Achse ist die Zeit und auf der vertikalen Achse sind entsprechende Pulssignale aufgetragen. Das Testsignal TS1 bzw. TS2 ist hier als Chebychev-Entwurf mit 41 Koeffizienten und einer Sperrdämpfung von 50 dB gewählt worden. Dabei war es Ziel des Testsignals, eine auf 31 Zeitwerte begrenztes Signal zu definieren, deren wesentliche Spektralkomponenten im zu nutzenden Trägerfrequenzband liegen.

FIG 4 zeigt mit Bezug auf FIG 3 den Frequenzgang des Testsignals TS1 bzw. TS2, wobei auf der horizontalen Achse die Frequenz und auf der vertikalen Achse zugehörige Amplitudenwerte aufgetragen sind.

Dabei weist das Testsignal eine gleiche komplexe Phase wie das maximale Nutzsignal S11 bzw. S21 im komplexen Basisband auf.

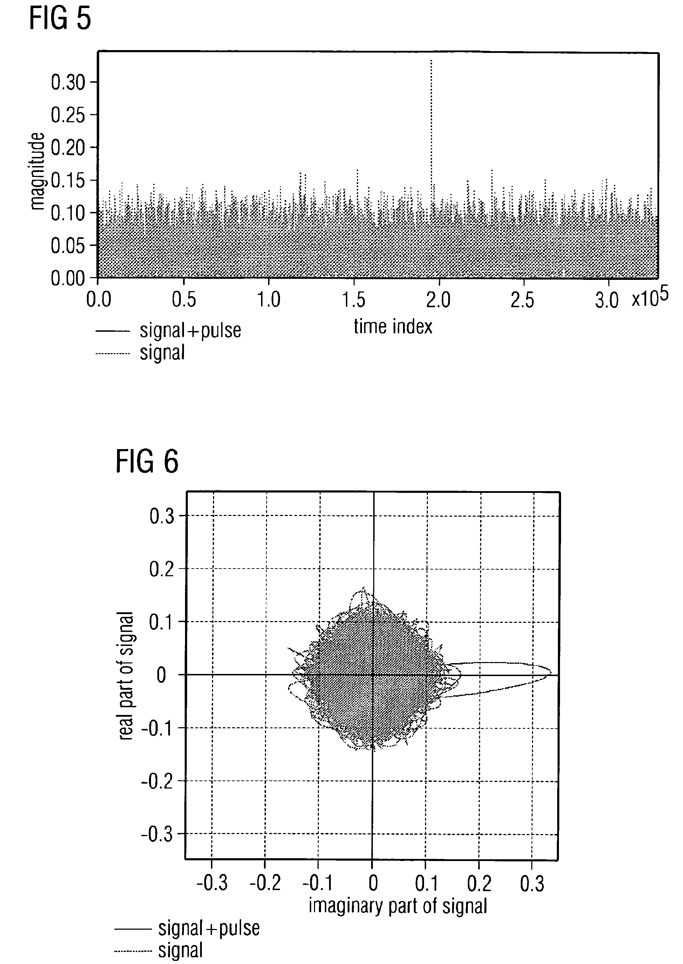

FIG 5 zeigt mit Bezug auf FIG 1 und FIG 2 das Ausgangssignal OUT1 bzw. OUT2 im zeitlichen Verlauf, wobei auf der horizontalen Achse die Zeit und auf der vertikalen Achse Amplituden aufgetragen sind. Dabei ist das überlagerte Testsignal deutlich bei t=2*10⁵ zu erkennen.

FIG 6 zeigt mit Bezug auf FIG 1 und FIG 2 das Ausgangssignal OUT1 bzw. OUT2 in komplexer Darstellung. Dabei ist das überlagerte Testsignal deutlich in einem keulenförmigen Verlauf zu erkennen.

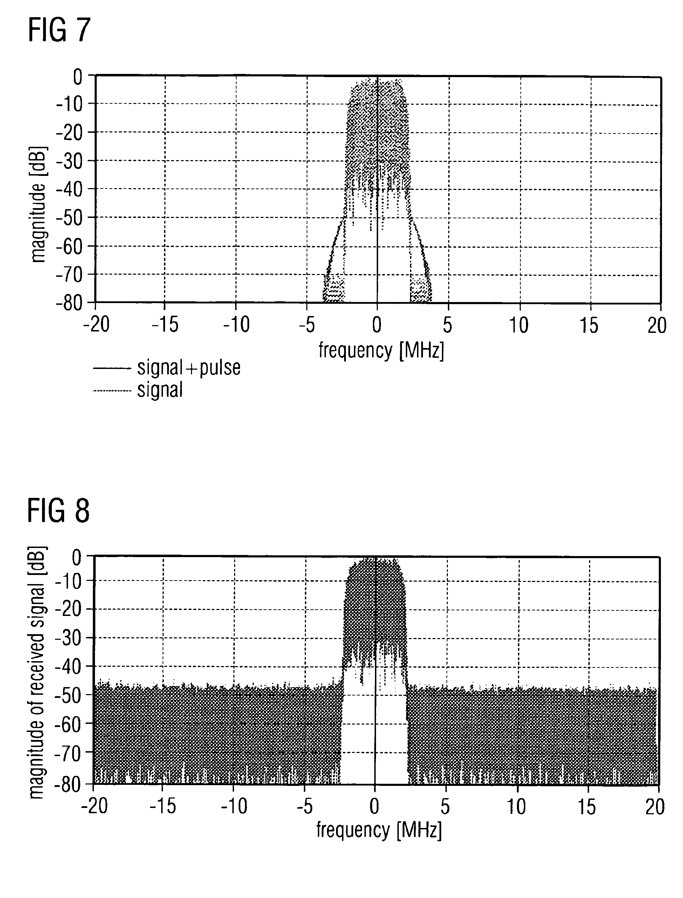

FIG 7 zeigt mit Bezug auf FIG 6 den Frequenzgang des Ausgangssignals OUT1 bzw. OUT2, wobei auf der horizontalen Achse die Frequenz und auf der vertikalen Achse Amplituden aufgetragen sind.

FIG 8 zeigt mit Bezug auf FIG 7 einen seitens eines Empfängers gemessenen Ausgangssignal-Frequenzgang, wobei auf der horizontalen Achse die Frequenz und auf der vertikalen Achse Empfangsamplituden aufgetragen sind. Dabei wird vorausgesetzt, dass das gemessene Signal durch additiv überlagertes weißes, gaußverteiltes Rauschen gestört wird.

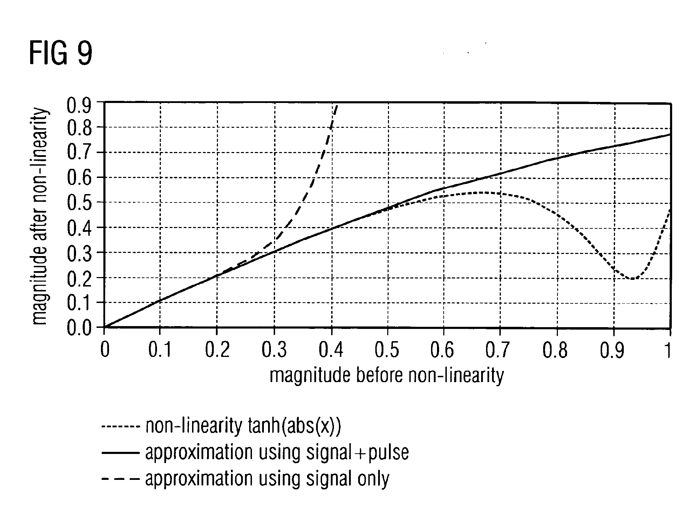

FIG 9 zeigt einen Vergleich eines erzielten Adaptionsergebnisses an eine nichtlineare Verstärkerkennlinie, bezeichnet mit "non-linearity tanh(abs(x))". Dabei handelt es sich um die in FIG 9 gezeigte mittlere Kennlinie.

Auf der horizontalen Achse ist ein Betrag der Amplitude des dritten Signals S13 bzw. des vierten Signals S24 dargestellt. Auf der vertikalen Achse ist ein Betrag der Amplitude des Ausgangssignals OUT1 bzw. OUT2 dargestellt - nach einer durchzuführenden Demodulation und Analog/Digital-Wandlung.

Zu erkennen ist eine Abweichung einer konventionellen Schätzung der Nichtlinearität der Verstärkerkennline bei zunehmender Amplitude - Kennlinie bezeichnet mit "approximation using signal only". Dabei handelt es sich um die in FIG 9 gezeigte linke Kennlinie.

Demgegenüber ist die geschätzte Nichtlinearität bei erfindungsgemäßer Verwendung des als "pulse" bezeichneten Testsignals wesentlich länger in Übereinstimmung mit der nichtlinearen Verstärkerkennlinie - Kennlinie bezeichnet mit "approximation using signal+pulse". Dabei handelt es sich um die in FIG 9 gezeigte rechte Kennlinie.

## Patentansprüche

1. Verfahren zur Linearisierung einer Leistungsverstärkerkennlinie,
- bei dem aus einem digitalen Eingangssignal (IN11) durch Vorverzerrung (PRE1) ein erstes Signal (S11) gebildet wird, das nach einer Trägerfrequenzumsetzung (UP), einer D/A-Wandlung (DAW1) und einer Modulation (MOD12) einem Leistungsverstärker (PA1) zur Bildung eines trägerfrequenten Ausgangssignals (OUT1) zugeführt wird,
- bei dem zur Linearisierung der Leistungsverstärkerkennlinie die Vorverzerrung (PRE1) durch Parameter (PAR11) gesteuert durchgeführt wird,
**dadurch gekennzeichnet,**
- **dass** dem ersten Signal (S11) ein Testsignal (TS1) überlagert wird, wodurch das Ausgangssignal (OUT1) neben einem trägerfrequenten Eingangssignalanteil (INA11) zusätzlich einen trägerfrequenten Testsignalanteil (TSA1) aufweist, und
- **dass** durch einen Vergleich des trägerfrequenten Testsignalanteils (TSA1) des Ausgangssignals (OUT1) mit dem Testsignal (TS1) die Parameter (PAR11) zur Steuerung der Vorverzerrung (PRE1) gebildet werden.

2. Verfahren nach Anspruch 1, **dadurch gekennzeichnet, dass** zur Bildung der Parameter (PAR11) ein zusätzlicher Vergleich des im Ausgangssignal (OUT1) enthaltenen Eingangssignalanteils (INA11) mit dem ersten Signal (S11) und/oder mit dem Eingangssignal (IN11) durchgeführt wird.

3. Verfahren zur Linearisierung einer Leistungsverstärkerkennlinie,
- bei dem aus einem digitalen Eingangssignal (IN21) durch Vorverzerrung (PRE2) ein vorverzerrtes Signal (S23) gebildet wird, das nach einer Trägerfrequenzumsetzung (UP), einer D/A-Wandlung (DAW2) und einer Modulation (MOD22) einem Leistungsverstärker (PA2) zur Bildung eines trägerfrequenten Ausgangssignals (OUT2) zugeführt wird,
- bei dem zur Linearisierung der Leistungsverstärkerkennlinie die Vorverzerrung (PRE2) durch Parameter (PAR21) gesteuert durchgeführt wird,
**dadurch gekennzeichnet,**
- **dass** dem Eingangssignal (IN21) als erstem Signal (S21) ein Testsignal (TS2) überlagert wird, wodurch das Ausgangssignal (OUT2) neben einem trägerfrequenten Eingangssignalanteil (INA21) zusätzlich einen trägerfrequenten Testsignalanteil (TSA2) aufweist, und
- **dass** durch einen Vergleich des trägerfrequenten Testsignalanteils (TSA2) des Ausgangssignals (OUT2) mit dem Testsignal (TS2) die Parameter (PAR21) zur Steuerung der Vorverzerrung (PRE2) gebildet werden.

4. Verfahren nach Anspruch 3, **dadurch gekennzeichnet, dass** zur Bildung der Parameter (PAR11) ein zusätzlicher Vergleich des im Ausgangssignal (OUT2) enthaltenen Eingangssignalanteils (INA11) mit dem verzerrten Signal (S23) und/oder mit dem ersten Signal (S21) durchgeführt wird.

5. Verfahren nach Anspruch 1 oder 2, **dadurch gekennzeichnet, dass** als Testsignal (TS1, TS2) ein Impulssignal mit einer zeitvarianten Amplitudenstatistik verwendet wird, dessen einzelne Amplituden vernachlässigbare störende Anteile in Trägerfrequenzbereichen bilden, die zu einem zu nutzenden Trägerfrequenzbereich des Leistungsverstärkers (PA) benachbart sind.

6. Verfahren nach Anspruch 1 oder 2, **dadurch gekennzeichnet, dass** das Testsignal (TS1, TS2) additiv (ADD1, ADD2) überlagert wird.

7. Verfahren nach Anspruch 1 oder 2, **dadurch gekennzeichnet, dass** das Testsignal (TS1, TS2) durch Parameter (PAR12, PAR22) gesteuert gebildet wird, die aus einem Vergleich des trägerfrequenten Testsignalanteils (TSA1, TSA2) des Ausgangssignals (OUT1, OUT2) mit dem Testsignal (TS1, TS2) gebildet werden.

8. Verfahren nach Anspruch 1 oder 2, **dadurch gekennzeichnet, dass** das Eingangssignal (IN11, IN21) durch Interpolation (IP1, IP2) und Modulation (MOD11, MOD21) eines komplexen digitalen Basisband-Eingangssignals (BBS) gebildet wird.

9. Verfahren nach Anspruch 8, **dadurch gekennzeichnet, dass** beim Vergleich zur Bildung der Parameter (PAR11, PAR21), die zur Steuerung der Vorverzerrung (PRE1, PRE2) verwendet werden, das digitalen Basisband-Eingangssignal (BBS) berücksichtigt wird.

10. Verfahren nach Anspruch 8, **dadurch gekennzeichnet, dass** am digitalen Basisband-Eingangssignal (BBS) vor der Interpolation (IP1, IP2) und vor der Modulation (MOD11, MOD21) ein durch Parameter (PAR13, PAR23) gesteuertes Basisband-Clipping-Verfahren (BBC) durchgeführt wird, wobei diese Parameter (PAR13, PAR23) ebenfalls durch Vergleich des Ausgangssignals (OUT1, OUT2) mit dem digitalen Basisband-Eingangssignal (BBS) gebildet werden.

11. Verfahren nach Anspruch 10, **dadurch gekennzeichnet, dass** eine beim Basisband-Clipping-Verfahren (BBC) verwendete Clipping-Schwelle adaptiv an Eigenschaften des Leistungsverstärkers (PA1, PA2) angepasst wird.

12. Anordnung zur Linearisierung einer Leistungsverstärkerkennlinie,
- bei der eine Vorverzerrungseinrichtung (PRE1), die gesteuert durch Parameter (PAR11) aus einem eingangsseitig angeschalteten Eingangssignal (IN11) ein vorverzerrtes erstes Signal (S11) bildet, ausgangsseitig mit einer Überlagerungseinrichtung (ADD1) verbunden ist, wobei die Überlagerungseinrichtung (ADD1) durch Überlagerung des ersten Signals (S11) mit einem Testsignal (TS1) ein zweites Signal (S12) bildet,
- bei der ein Ausgang der Überlagerungseinrichtung (ADD1) über eine Einrichtung zur Trägerfrequenzumsetzung (UP1), einen D/A-Wandler (DAW1) und einen Modulator (MOD12) mit dem Eingang des Leistungsverstärker (PA1) verbunden ist, wodurch aus dem zweiten Signal (S12) ein trägerfrequentes Ausgangssignal (OUT1) gebildet wird,
- bei der der Ausgang der Überlagerungseinrichtung (ADD1) mit einer Steuereinrichtung (SE1) verbunden ist, wodurch dieser das zweite Signal (S12) zugeführt wird,
- bei der der Leistungsverstärker (PA1) ausgangsseitig mit der Steuereinrichtung (SE1) verbunden ist, wodurch diese aus einem Vergleich eines im Ausgangssignal (OUT1) enthaltenen Testsignalanteils (TSA1) mit dem im zweiten Signal (S12) enthaltenen Testsignal (TS1) die Parameter (PAR11) zur Steuerung der Vorverzerrung (PRE1) bildet.

13. Anordnung nach Anspruch 12, bei der die Vorverzerrungseinrichtung (PRE1) eingangsseitig zusätzlich mit der Steuereinrichtung (SE1) verbunden ist, wodurch bei der Bildung der Parameter (PAR11) das Eingangssignal (IN11) zusätzlich berücksichtigt wird.

14. Anordnung zur Linearisierung einer Leistungsverstärkerkennlinie,
- bei der eine Überlagerungseinrichtung (ADD2), die aus einem eingangsseitig angeschalteten Eingangssignal (IN21, S21) durch Überlagerung mit einem Testsignal (TS2) ein zweites Signal (S22) bildet, ausgangsseitig mit einer Vorverzerrungseinrichtung (PRE2) verbunden ist, wobei die Vorverzerrungseinrichtung (PRE2) gesteuert durch Parameter (PAR11) aus dem zweiten Signal (S22) ein vorverzerrtes Signal (S23) bildet,
- bei der die Vorverzerrungseinrichtung (PRE2) ausgangsseitig über eine Einrichtung zur Trägerfrequenzumsetzung (UP2), einen D/A-Wandler (DAW2) und einen Modulator (MOD22) mit dem Eingang des Leistungsverstärker (PA2) verbunden ist, wodurch aus dem vorverzerrten Signal (S23) ein trägerfrequentes Ausgangssignal (OUT2) gebildet wird,
- bei der die Überlagerungseinrichtung (ADD2) ausgangsseitig mit einer Steuereinrichtung (SE2) verbunden ist, wodurch dieser das zweite Signal (S22) zugeführt wird,
- bei der der Leistungsverstärker (PA2) ausgangsseitig mit der Steuereinrichtung (SE2) verbunden ist, wodurch diese aus einem Vergleich eines im Ausgangssignal (OUT2) enthaltenen Testsignalanteils (TSA2) mit dem im zweiten Signal (S22) enthaltenen Testsignal (TS2) die Parameter (PAR21) zur Steuerung der Vorverzerrung (PRE2) bildet.

15. Anordnung nach Anspruch 14, bei der die Vorverzerrungseinrichtung (PRE2) ausgangsseitig zusätzlich mit der Steuereinrichtung (SE2) verbunden ist, wodurch bei der Bildung der Parameter (PAR21) das vorverzerrte Signal (S23) zusätzlich berücksichtigt wird.

16. Anordnung nach Anspruch 12 oder 14, bei der die Steuereinrichtung (SE1, SE2) mit einem Pulsgenerator (PG1, PG2) verbunden ist, der das Testsignal (TS1, TS2) bildet und der durch Parameter (PAR12, PAR22) der Steuereinrichtung (SE1, SE2) gesteuert wird.

17. Anordnung nach Anspruch 12 oder 14, bei der die Steuereinrichtung (SE1, SE2) zur Durchführung eines Peak-Detection-Verfahrens (PD), eines Leistungsschätzungsverfahrens (PE) und/oder eines "NL system identification"-Verfahrens (NLSYSIDENT) ausgebildet ist.

18. Anordnung nach einem der Ansprüche 12 bis 17, bei der der Überlagerungseinrichtung (ADD1, ADD2) eine Interpolationseinrichtung (IP1, IP2) und ein Modulator (MOD11, MOD21) derart vorgeschaltet sind, dass aus einem an der Interpolationseinrichtung (IP1, IP2) angeschalteten komplexen Basisbandsignal (BBS) das Eingangssignal (IN11, IN21) gebildet wird.

19. Anordnung nach 18, bei der der Interpolationseinrichtung (IP1, IP2) eingangsseitig eine Einrichtung zur Durchführung eines Basisband-Clipping-Verfahrens (BBC) vorgeschaltet ist, über die das Basisbandsignal (BBS) an die Interpolationseinrichtung (IP1, IP2) gelangt, wobei diese Einrichtung (BBC) durch Parameter (Par13, PAR23) der Steuereinrichtung (SE1, SE2) gesteuert wird.

20. Anordnung nach Anspruch 19, bei der die Einrichtung zur Durchführung eines Basisband-Clipping-Verfahrens (BBC) eingangsseitig mit der Steuereinrichtung (SE1, SE2) verbunden ist, wodurch diese bei der jeweiligen Parameterbildung das Basisbandsignal (BBS) berücksichtigt.
